# EUROPÄISCHE PATENTSCHRIFT

(11) **EP 0 581 152 B1**
(45) Veröffentlichungstag und Bekanntmachung des Hinweises auf die Patenterteilung: **15.10.1997**
(21) Anmeldenummer: 93111497.9
(22) Anmeldetag: 17.07.1993
(51) Int. Cl.: H01L 23/485, H01L 23/488, H01L 21/60, H01L 23/498

(54) **Verfahren zur Herstellung eines Multichipmoduls mittels Kontakhöcker**
Method of manufacture of a multichip module using bump contacts
Procédé pour la fabrication d'une module multipuce avec des électrodes à protubérance

(30) Priorität: 30.07.1992 DE 4225138
(43) Veröffentlichungstag der Anmeldung: 02.02.1994
(73) Patentinhaber: Daimler-Benz Aktiengesellschaft, 70546 Stuttgart (DE); AEG Infrarot-Module GmbH, 74072 Heilbronn (DE)
(72) Erfinder: Kuisl, Max, Dr. rer. nat., D-89079 Ulm (DE); Ziegler, Johann, Dipl.-Ing., D-74257 Untereisesheim (DE)
(74) Vertreter: Kolb, Georg

(56) Entgegenhaltungen:
- EP-A- 0 475 223
- IEE PROCEEDINGS H. MICROWAVES, ANTENNAS & PROPAGATION Bd. 138, Nr. 1, Februar 1991, STEVENAGE GB Seiten 74 - 78 K.L.PICKERING ET AL. 'Flip-chip bonded GaAs MMICs copatible with foundry manufacture'
- IEEE TRANSACTIONS ON COMPONENTS,HYBRIDS,AND MANUFACTURING TECHNOLOGY Bd. 13, Nr. 2, Juni 1990, NEW YORK US Seiten 444 - 447 M.MORI ET AL. 'A new face down bonding technique using a low melting point metal'
- 1990 IEEE INTERNATIONAL SOLID-STATE CIRCUITS CONFERENCE (ISSCC 90), SAN FRANCISCO, CA, US, 14-16 FERBRUARY 1990 S.HARADA ET AL. 'Fine-pitch high- density PGA package' Seiten 154-155 + 288
- IEEE TRANSACTIONS ON COMPONENTS,HYBRIDS,AND MANUFACTURING TECHNOLOGY Bd. 14, Nr. 2, Juni 1991, NEW YORK US Seiten 407 - 412 C.C.LEE ET AL. 'A new bonding technology using gold and tin multilayer composite structures'

## Beschreibung

Die Erfindung betrifft ein Verfahren zur Herstellung von Multichipmodulen nach dem Oberbegriff des Patentanspruchs 1.

Der Trend zu immer kleineren Bauteilen und immer höheren Frequenzen hat neben der Erhöhung der Integrationsdichte auf ICs zur Entwicklung von Multichipmodulen (MCM) geführt. In einem Multichipmodul werden mehrere Chips mit unterschiedlichen Funktionen und unter Umständen aus unterschiedlichen Materialien auf einem gemeinsamen Substrat montiert. Da hierbei die ungehäusten Chips zum Einsatz kommen, werden die Gehäusekosten eingespart und der Platzbedarf reduziert sich auf die Fläche des Chips. Insbesondere seit Silizium als Substrat für MCMs eingesetzt wird, ist ein erheblicher Fortschritt zu verzeichnen. Denn Silizium hat nicht nur ausgezeichnete Materialeigenschaften (z.B. hohe Wärmeleitfähigkeit), sondern auf ihm können die Methoden der herkömmlichen IC-Technik eingesetzt werden. Die Leiterbahnstrukturen zur elektrischen Verbindung der Chips untereinander und nach außen können mit entsprechend kleinen Abmessungen und Strukturbreiten und trotzdem hoher Zuverlässigkeit realisiert werden. Die elektrische Verbindung der Chips zu den Leiterbahnen auf dem Substrat erfolgt heute noch vorzugsweise mit der Drahtbondtechnik. Beispiele für diese Technik sind zum Beispiel in der Zeitschrift Galvanotechnik, Nr. 83, Nr. 4, Seite 1362-1369 (1992) beschrieben.

Die Bondtechnik wird jedoch als eine Beschränkung der Multichiptechnik angesehen: Die Bonds werden seriell ausgeführt, die Montage dauert daher entsprechend lang und ist daher relativ teuer, außerdem erfordern die Kontaktflächen auf dem Substrat außerhalb der IC-Chipgeometrie zusätzlichen Flächenbedarf. Durch die langen Bonddrähte entstehen zusätzlich noch unerwünschte Induktivitäten. Diese Nachteile vermeidet die sogannte Flip-Chip-Technik. Bei dieser Technik werden in herkömmlichen Verfahren lötbare Kontakthöcker (bumps) auf die Kontaktflächen der IC aufgebracht und diese mit einem entsprechend vorbereitetem Substrat verbunden (siehe z.B. EP-A- 0 475 223 und M. Mori et al. in IEEE Transactions on Components, Hybrids and Manufacturing Technology 13 (1990), Seite 444-447). Durch Aufheizen und Aufschmelzen des Lots entsteht eine dauerhafte Verbindung zwischen den Chipkontakten und den Kontaktflächen auf dem Substrat. Zwei Voraussetzungen müssen jedoch erfüllt sein:
1. Das Lot darf die Aluminiumschicht der Substrat-Kontaktfläche nicht angreifen. Daher wird zwischen Kontaktfläche und Lot eine Barriereschicht aufgebracht, die auch gleichzeitig einen ohmschen Kontakt gewährleistet.
2. Das Lot muß die vorgesehene Kontaktfläche benetzen. Ist dies nicht der Fall, so entsteht kein Kontakt. Als großer Nachteil wird angesehen, daß ein auf das Chip genau angepaßtes Substrat vorliegen muß, während diese Forderung beim Drahtbonden nicht so streng erfüllt sein muß, da über die Drahtführung noch eine gewisse Flexibilität besteht.

In IEEE Proceedings H. Microwaves, Antennas and Propagation, Band 138(1), 1991, Seiten 74-78 K.L. Pickering et al.: wird die Herstellung von lötbaren Kontakthöckern auf einem Keramiksubstrat beschrieben. Um jedoch den Chip mit dem vorbereiteten Substrat zu verbinden, müssen die Kontakte des Chip mit einer Metallbarrierenschicht geschützt und durch eine weitere durch das Lot benetzbare Schicht beschichtet werden. Die Verbindung von Substrat und Chip erfolgt durch Erhitzen der Kompenenten über die flüssige Löttemperatur des Materials der Kontakthöcker.

Der Erfindung liegt die Aufgabe zugrunde, ein Verfahren zur Herstellung von Multichipmodulen anzugeben, so daß unter Verwendung der Flip-Chip-Technik beliebige Chips mit Standardkontaktkonfigurationen und ohne zusätzliche Verfahren technisch einfach und zuverlässig auf dem Substrat aufgebracht werden können.

Die Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen zu entnehmen.

Vorteilhaft für die Herstellung von Multichipmodulen gemäß der Erfindung ist die Verwendung von Siliziumsubstraten, die eine Verdrahtungsebene, z.B. aus Aluminium besitzen. Da für die Verdrahtungsebene sowieso eine spezielle Maske entworfen werden muß, können auch die für die Flip-Chip-Technik notwendigen Kontakthöcker in dieser Maske mitberücksichtigt werden. Es ist deshalb kein zusätzlicher Maskenentwurf bei der Herstellung der Kontakthöcker auf dem Siliziumsubstrat notwendig. Durch die Verwendung von Siliziumsubstraten läßt sich die Bumptechnik ohne weiteres vom Chip auf das Substrat übertragen. Damit ist eine Verlagerung der Bumptechnologie vom Halbleiterhersteller auf den Modulhersteller möglich.

Die Herstellung der Kontakthöcker auf dem Substrat stellt an die Barriereschicht zwischen Kontakthöcker und Substrat weniger hohe Anforderung als bei der Herstellung der Kontakthöcker auf dem Chip, da auf dem Substrat keine Bauelemente geschützt werden müssen.

Bei der Herstellung der Kontakthöcker auf dem Substrat müssen die Lötkontakte (bumps) mit dem Aluminium der IC-Kontaktflächen eine zuverlässige elektrische und mechanische Verbindungen bilden.

Nun ist aber Aluminium von Loten in der Regel nicht benetzbar, da sich Aluminium beim Lagern in Luft mit einer dünnen Aluminiumoxidschicht überzieht. Ein weiteres Problem ist, daß die üblichen Lote bei den hohen Temperaturen, die während des Lötens auf das Bauteil wirken, Aluminium auslösen. Um dies zu vermeiden, wurde bei der Standard-Bumptechnik die Barriereschicht eingefügt. Für die Herstellung eines Multichipmoduls gemäß der Erfindung muß daher ein Lot oder ein Verbindungsverfahren gefunden werden, welches Aluminium zwar benetzt aber nicht auflöst.

Anhand des folgenden Ausführungsbeispiels wird die Erfindung näher erläutert. Ein Siliziumsubstrat wird thermisch oxidiert und auf der dabei entstandenen Oxidschicht mit der üblichen Technik eine Leiterbahnebene z.B. aus Aluminium oder Polysilizium aufgebracht. Dazu wird Aluminium entweder aufgedampft oder gesputtert. Mit einem Fotolack- und einem Ätzschritt werden in der Aluminiumschicht die vorgegebenen Strukturen erzeugt. Wie in der IC-Technik üblich werden anschließend die Leiterbahnen mit Siliziumdioxid oder Siliziumnitrid passiviert und die Kontaktfenster für den elektrischen Anschluß freigelegt. Nun folgen die bei der Bumptechnik üblichen Prozeßschritte. Dazu wird zunächst eine Folge verschiedener Metallschichten aufgedampft oder aufgesputtert. Die Strukturierung dieser Schichten erfolgt in der Weise, daß die Kontaktfenster mit diesen Schichten überlappend bedeckt werden. Die Ausdehnung dieser Schicht begrenzt später die bumps (under bump metallization = UBM). Für die Schichtenfolge der UBM werden in der Literatur verschiedene Kombinationen angegeben. In der Regel handelt es sich um eine Haftschicht, eine Diffusionsbarriere und eine Antikorrosionsschicht. Beispiele hierzu kann man aus der Veröffentlichung "Multichip Assembly with Flipped Integrated Circuits" entnehmen, welche in IEEE Trans. on Electron. Devices 12, 650 (1989) erschienen ist. Für die Haftschicht können z.B. Chrom oder Titan oder Titan/Wolfram-Legierungen, für die Barriereschicht z.B. Nickel oder Kupfer und für die Antikorrosionsschicht kann z.B. Gold verwendet werden.

Die bumps bestehen in unserem Anwendungsbeispiel aus Indium, welches ganzflächig aufgedampft und über einen lift-off-Prozeß strukturiert wird. Es entstehen Indium-Flächen, welche die UBM etwas überlappen. Beim Erhitzen des Substrates über den Schmelzpunkt des Indiums zieht sich das Indium-Lot auf die Fläche der UBM zurück. Das Flächenverhältnis von Indiumschicht zu UBM bestimmt das Volumen der bumps und damit deren Höhe.

Auf ein dermaßen vorbereitetes Substrat mit der entsprechenden Anschlußkonfiguration können nun Chips verschiedener Hersteller aufgebaut werden. Die Chips werden upside down auf die vorbereiteten bumps gelegt und angepreßt. Dabei findet eine simultane Kaltverschweißung aller Aluminium-Kontakte mit den Indium-bumps statt. Die Verbindung ist zuverlässig, der elektrische Kontaktwiderstand ist vernachlässigbar.

Die bumps haben einen Durchmesser von ca. 20µm und sind etwa 20µm hoch. Die Justage kann auf 1µm genau durchgeführt werden. Die Kontaktflächen auf den ICs sind normalerweise für Bonddrähte ausgelegt und sind 100 x 100µm² groß. Daraus wird ersichtlich, daß bei breitem Einsatz der oben beschriebenen Flip-Chip-Technik die Kontaktflächen auf den ICs, die einen beträchtlichen Anteil auf dem Chip ausmachen, reduziert werden können.

Ein weiterer Vorteil ist die Möglichkeit, die IC-Kontaktflächen über die gesamte Chipfläche zu verteilen (Standard ist die Anordnung der Kontaktflächen im Randbereich der Chips). Dadurch sind mehr Kontaktflächen, d.h. eine höhere Pinzahl bei reduzierter Fläche herstellbar.

Die Anwendung der beschriebenen Verbindungstechnik ist nicht auf den Einsatz von Indium als Bumpmaterial beschränkt, sondern kann auch mit anderen üblichen Materialien für bumps durchgeführt werden, oder es werden neue spezielle für Aluminium geeignete Materialien eingesetzt, z.B. Gold oder Lotverbindungen wie Blei/Zinn oder Indium/Wismuth.

Die Anwendung ist nicht auf Halbleitersubstrate beschränkt, sondern kann auf beliebigen Substraten durchgeführt werden, z.B. auf Keramiksubstraten, Saphir, Glas und Kunststoffen.

Desweiteren können die Substrate zusätzlich passive und aktive Bauelemente enthalten, die mit den herkömmlichen Methoden hergestellt werden.

## Patentansprüche

1. Verfahren zur Herstellung von elektrischen Kontakten für ein Multichipmodul unter Verwendung der Flip-Chip-Technik, wobei Kontakthöcker auf einer oder mehreren Leiterbahnebenen, die auf einem Substrat aufgebracht sind, hergestellt werden, einzelne Chips des Multichipmoduls auf die vorbereiteten Kontakthöcker aufgebracht werden und die elektrische Verbindung der Chips zu den Leiterbahnebenen mittels auf der Oberfläche der Chips aufgebrachter Kontakte hergestellt wird, dadurch gekennzeichnet,
- daß Aluminium-Kontakte der Chips direkt als Kontaktflächen für die Kontakthöcker verwendet werden, und
- daß die Kontakte der Chips auf die Kontakthöcker gepreßt und kaltverschweißte Kontakte hergestellt werden.

2. Verfahren nach Anspruch 1, dadurch gekennzeichnet, daß zur Herstellung der Kontakthöcker auf einem Siliziumsubstrat mit Isolatorschicht eine Leiterbahnebene aufgebracht wird,
- daß die Leiterbahnebene passiviert wird und anschließend die Kontaktfenster für die elektrischen Anschlüsse freigelegt werden,
- daß mehrere Metallschichten auf die passivierte Leiterbahnebene aufgebracht werden und derart strukturiert werden, daß Metallflächen die Kontaktfenster überlappend bedecken,
- daß auf die Metallflächen ein geeignetes Material für die Kontakthöcker ganzflächig aufgedampft und über einen lift-off-Prozeß strukturiert wird, derart, daß die Metallflächen mit dem Material überlappend bedeckt werden, und
- daß das Substrat über den Schmelzpunkt des Materials der Kontakthöcker erhitzt wird, so daß sich auf den Metallflächen Kontakthöcker ausbilden.

3. Verfahren nach Anspruch 2, dadurch gekennzeichnet, daß die Leiterbahnen aus Aluminium oder Polysilizium hergestellt werden.

4. Verfahren nach Anspruch 2, dadurch gekennzeichnet, daß die Metallflächen aus einer Schichtenfolge aus einer Haftschicht, einer Diffusionsbarrierenschicht und einer Antikorrosionsschicht gebildet werden.

5. Verfahren nach Anspruch 4, dadurch gekennzeichnet, daß die Haftschicht aus Chrom oder Titan oder Titan/Wolfram-Legierungen gebildet wird.

6. Verfahren nach Anspruch 4, dadurch gekennzeichnet, daß die Diffusionsbarrierenschicht aus Nickel oder Kupfer gebildet wird.

7. Verfahren nach Anspruch 4, dadurch gekennzeichnet, daß die Antikorrosionsschicht aus Gold hergestellt wird.

8. Verfahren nach Anspruch 2, dadurch gekennzeichnet, daß die Kontakthöcker aus Indium, Gold oder Lötverbindungen wie Blei/Zinn oder Indium/Wismuth hergestellt werden.

## Claims

1. A process for producing electric contacts for a multichip module using flip-chip technology, wherein bonding pads are produced on one or more conductor path plane(s), which are applied to a substrate, individual chips of the multichip module are applied to the prepared bonding pads, and the electric connection of the chips to the conductor path planes is produced by means of contacts arranged on the surface of the chips, characterised in that
- aluminium contacts of the chips are used directly as contact surfaces for the bonding pads and
- the contacts of the chips are pressed onto the bonding pads and cold-welded contacts are produced.

2. A process according to claim 1, characterised in that
- for producing the bonding pads a conductor path plane is applied to a silicon substrate with an insulating layer,
- the conductor path plane is passivated and then the contact windows for the electric terminals are exposed
- a plurality of metallic layers are applied to the passivated conductor path plane and structured in such manner that the metallic surfaces cover the contact windows in an overlapping fashion
- a suitable material for the bonding pads is vapour-deposited onto the whole area of the metallic surfaces and is structured via a lift-off process in such manner that the metallic surfaces are covered with the material in an overlapping fashion and
- the substrate is heated above the melting point of the material of the bonding pads so that bonding pads form on the metallic surfaces.

3. A process according to Claim 2, characterised in that the conductor paths are formed from aluminium or polysilicon.

4. A process according to Claim 2, characterised in that the metallic surfaces are formed from a layer sequence comprising a bonding layer, a diffusion barrier layer and an anti-corrosion layer.

5. A process according to Claim 4, characterised in that the bonding layer is formed from chromium or titanium or titanium/tungsten alloys.

6. A process according to Claim 4, characterised in that the diffusion barrier layer is formed from nickel or copper.

7. A process according to Claim 4, characterised in that the anti-corrosion layer is produced from gold.

8. A process according to Claim 2, characterised in that the pillars are produced from indium, gold or solder compounds such as lead/tin or indium/bismuth.

## Revendications

1. Procédé de fabrication de contacts électriques pour un module multipuce en employant la technique des puces à protubérances, dans lequel on fabrique des protubérances de contact sur un ou plusieurs niveaux d'interconnexion des rubans conducteurs, rapportés sur un substrat et l'on applique différentes puces du module multipuce sur les protubérances de contact ainsi préparées, et dans lequel on réalise la liaison électrique des puces avec les niveaux d'interconnexion des rubans conducteurs au moyen de contacts rapportés sur la surface des puces, caractérisé
- par le fait que l'on emploie directement des contacts en aluminium des puces comme surfaces de contact pour les protubérances de contact et
- que l'on presse les contacts des puces sur les protubérances de contact et que l'on réalise ainsi des contacts soudés à froid.

2. Procédé selon la revendication 1, caractérisé par le fait
- que, pour fabriquer les protubérances de contact, on rapporte un niveau d'interconnexion des rubans conducteurs sur un substrat de silicium comportant une couche isolante,
- que l'on passive le niveau d'interconnexion des rubans conducteurs et qu'on libère ensuite les fenêtre de contact pour les raccords électriques,
- que, sur le plan d'interconnexion des rubans conducteurs, passivé on rapporte plusieurs couches métalliques et qu'on les structure de façon que des surfaces métalliques couvrent, à recouvrement mutuel, les fenêtres de contact,
- que, sur les surfaces métalliques, on rapporte, par évaporation sous vide, sur la totalité de la surface, un matériau approprié pour les protubérances de contact et qu'on le structure par un processus d'arrachement de façon que les surfaces métalliques soient couvertes, à recouvrement mutuel, par le matériau et
- que l'on chauffe le substrat au-dessus du point de fusion du matériau des protubérances de contact de façon que des protubérances de contact se forment sur les surfaces métalliques.

3. Procédé selon la revendication 2, caractérisé par le fait que les rubans conducteurs sont fabriqués en aluminium ou en polysilicium.

4. Procédé selon la revendication 12, caractérisé par le fait que les surfaces métalliques sont constituées d'une suite de couches comprenant une couche d'adhérence, une couche formant barrière antidiffusion et une couche d'anticorrosion.

5. Procédé selon la revendication 4, caractérisé par le fait que la couche d'adhérence est formée de chrome ou de titane ou d'alliages titane/tungstène.

6. Procédé selon la revendication 4, caractérisé par le fait que la couche formant barrière antidiffusion est formée de nickel ou de cuivre.

7. Procédé selon la revendication 4, caractérisé par le fait que la couche d'anticorrosion est réalisée en or.

8. Procédé selon la revendication 2, caractérisé par le fait que les protubérances de contact sont constituées d'indium, d'or ou de composés pour soudure comme plomb/étain ou indium/bismuth.
